# EUROPEAN PATENT SPECIFICATION

(11) **EP 0 516 402 B1**
(45) Date of publication and mention of the grant of the patent: **24.09.1997**
(21) Application number: 92304808.6
(22) Date of filing: 28.05.1992
(51) Int. Cl.: H01L 21/60, H05K 3/34

(54) **Substrate provided with electric lines and its manufacturing method**
Mit elektrischen Leitungen versehenes Substrat und dessen Herstellungsverfahren
Substrat muni de lignes électriques et son procédé de fabrication

(30) Priority: 31.05.1991 JP 156123/91
(43) Date of publication of application: 02.12.1992
(73) Proprietor: International Business Machines Corporation, Armonk, N.Y. 10504 (US)
(72) Inventor: Shirai, Masaharu, Ohtsu-shi, Shiga-ken (JP); Yamanaka, Kimihiro, Kouka-gun, Shiga-ken (JP)
(74) Representative: Burt, Roger James, Dr.

(56) References cited:
- EP-A- 310 357
- US-A- 5 025 348
- PATENT ABSTRACTS OF JAPAN vol. 13, no. 386 (E-812)25 August 1989 & JP - A - 1 135 093
- PATENT ABSTRACTS OF JAPAN vol. 13, no. 330 (E-793)25 July 1989 & JP - A - 1 094 696.
- IBM TECHNICAL DISCLOSURE BULLETIN. vol. 32, no. 11, April 1990, NEW YORK US pages 38-39; 'Application of precision solder volumes to surface pads'
- PATENT ABSTRACTS OF JAPAN vol. 6, no. 200 (E-135)(1078) 9 October 1982 &JP - A - 57 107 042.

## Description

The present invention relates to a substrate provided with electric lines having pads (electric connecting portions) exposed from openings of an insulating film and to a method of manufacturing such a substrate. More particularly, the present invention relates to a technique for forming pads having predetermined areas in a predetermined positional relation while permitting a relative positional deviation between a part (pad connecting portion) of the electric line serving as a pad and an opening in the insulating film.

A substrate provided with electric lines has an insulating film provided on the substrate so as to cover the electric lines. To electrically connect the electric lines on the substrate with other circuits or apparatus, openings are formed in the insulating film in order to expose parts of the electric lines as pads.

It is required that the pad has a specified area in order to assure the reliability in the electrical connection. Particularly, in a small substrate provided with electric lines such as a substrate provided with electric lines to support an electronic circuit component ie a semiconductor chip or the like, since an area of the pad is inherently small, the area of the pad must satisfy a fairly high precision. Moreover, in the flip chip method where the pad on the substrate and the pad on the semiconductor chip are connected by a metal ball, not only are both of those pads electrically connected but also the semiconductor chip is attached to the substrate, the area of the pad is also important in terms of the strength of the attachment.

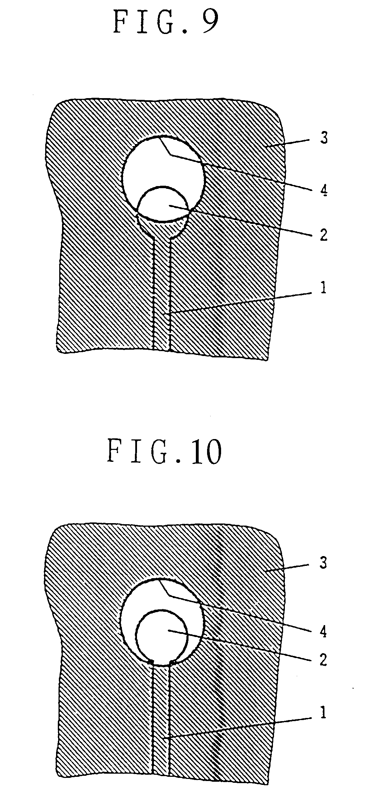

Figure. 9 shows the case where a position of an opening 4 formed in an insulating film 3 is deviated from a pad connecting portion 2 provided at a front edge of an electric line 1. If an exposure area of the electric line 1 made of a metal decreases more than a predetermined value the reliabilities in the electrical connection and attaching strength mentioned above are lost.

Since the process to form the electric line 1 on the substrate and the process to provide the insulating film 3 on the substrate and to form the opening 4 must be sequentially executed, a possibility such that the positional deviation between the pad connecting portion 2 and the opening 4 as mentioned above occurs is extremely high.

Even when the positional deviation is of a degree such that a part of the pad connecting portion 2 is covered by the insulating film 3 as shown in Fig. 9 does not occur, the problem of the reliability still exists. That is, even in the case where the pad connecting portion 2 lies within the opening 4 as shown in Figs. 10 and 11, the portion exposed through the opening 4 of the electric line 1 also functions as a connecting pad together with the pad connecting portion 2. Therefore, the whole pad area fluctuates due to the above positional deviation. Such a fluctuation of the pad area causes a difference from the design value. The reliabilities are lost from the above viewpoint.

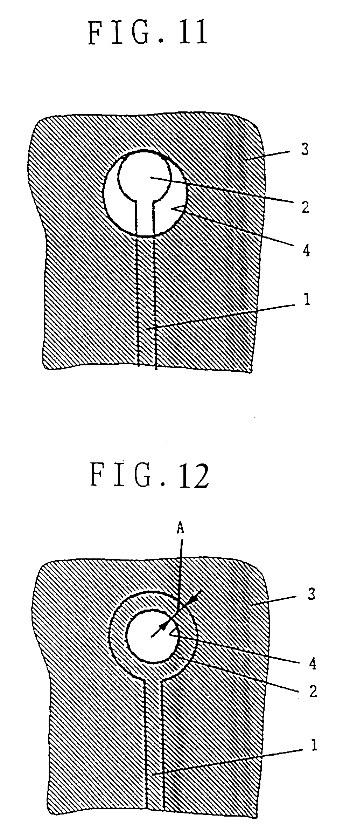

To solve the foregoing problem of the positional deviation, a method as shown in Fig. 12 has conventionally been considered.

According to the above method, the pad connecting portion 2 is formed in a disk shape whose radius is larger than that of the opening 4 by A and the opening 4 exposes a part of the pad connecting portion 2. Therefore, even when a positional deviation of the opening 4 to the pad connecting portion 2 occurs in any one of the upper, lower, right, and left directions, the opening 4 is located over the pad connecting portion 2 so long as such a positional deviation lies within a range of the length A. An area of the pad which is exposed from the opening 4 is held to a predetermined value which is determined by the area of the opening 4.

According to the method shown in Fig. 12, since the pad connecting portion 2 is formed larger than the size which is necessary to connect, the following new problems occur.

That is, since a plurality of pads are generally adjacently provided on the substrate provided with electric lines, in the case of forming the large pad connecting portions 2 as mentioned above, the neighbouring pads electrically interfere with each other. Since a number of pads are arranged on the substrate for a semiconductor chip at a high density, such an electric interference easily occurs and the above method cannot be used.

It is difficult to accurately form the pads while assuring a predetermined area as mentioned above. Therefore, a defective pad easily occurs due to the positional deviation of the opening formed in the insulating film and the yield of the products deteriorates. Further pad structures are disclosed in JP-A-1094696 and JP-A-1135093.

The present invention provides an electronic circuit board as claimed in claim 1 comprising: a substrate having electric lines formed thereupon; and an insulating film covering the electric lines and having an opening. The invention is characterised in that the electric lines each have one or more connection pads; and the insulating film has an opening corresponding to each of the connection pads, said opening having a width (D+2d) greater than the width (D) of the corresponding connection pad and a length (L) less than the length (L+2l) of the corresponding connection pad.

The invention also provides a method for manufacturing an electronic circuit package as claimed in claim 6 comprising the steps of: forming electric lines upon a substrate; covering the electric lines with an insulating film, the insulating film having an opening; and bonding an electronic component to the exposed connection pad by means of solder. The invention is characterised in that said step of forming electric lines further includes forming one or more connection pads for each electric line; and said step of covering the electric lines with an insulating film further includes the step of providina an opening corresponding to each of the connection pads, said opening having a width (D+2d) greater than the width (D) of the corresponding connection pad and a length (L) less than the length (L+2l) of the corresponding connection pad.

In order that the invention may be fully understood, preferred embodiments thereof will now be described, by way of example only, with reference to the accompanying drawings, in which:

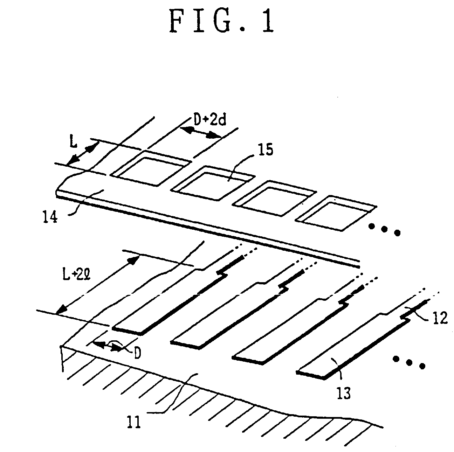

Fig. 1 is an exploded perspective view of a substrate provided with electric lines according to an embodiment of the invention;

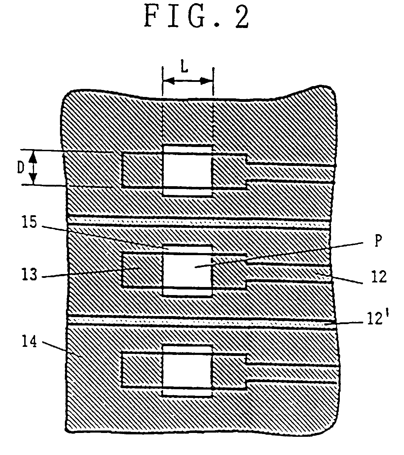

Fig. 2 is a plan view of the substrate provided with electric lines according to an embodiment of the invention;

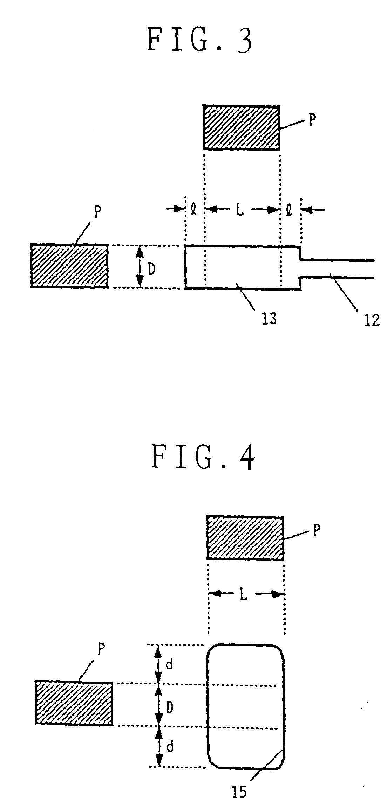

Fig. 3 is a conceptional diagram for explaining a size of electric line in accordance with the invention;
Fig. 4 is a conceptional diagram for explaining a size of opening of an insulating film in accordance with the invention;

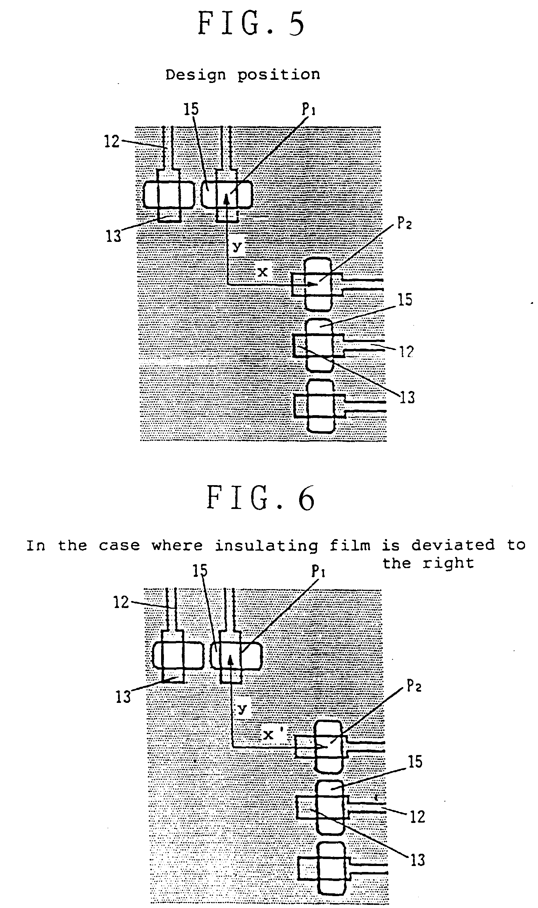

Fig. 5 is a conceptional diagram for explaining an arrangement of pads in accordance with the invention;
Fig. 6 is a conceptional diagram for explaining an arrangement of pads in accordance with the invention;

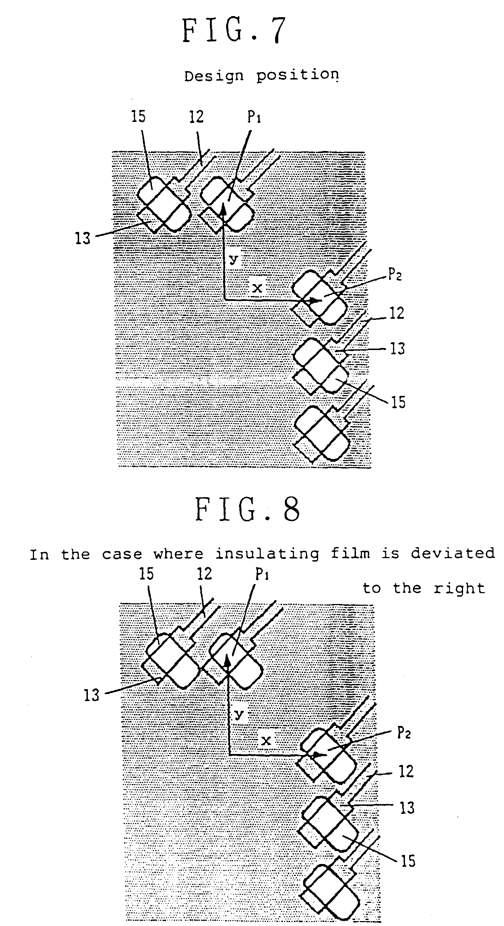

Fig. 7 is a conceptional diagram for explaining an arrangement of pads in accordance with the invention;
Fig. 8 is a conceptional diagram for explaining an arrangement of pads in accordance with the invention;
Fig. 9 is a conceptional diagram for explaining a problem in a conventional substrate provided with electric lines;
Fig. 10 is a conceptional diagram for explaining a problem in a conventional substrate provided with electric lines;
Fig. 11 is a conceptional diagram for explaining a problem in a conventional substrate provided with electric lines; and
Fig. 12 is a conceptional diagram for explaining a problem in a conventional substrate provided electric lines.

Fig. 1 shows a substrate provided with electric lines according to an embodiment of the invention. A plurality (four in the diagram) of electric lines 12 are formed on a substrate 11 made of an insulating material. Front edge portions of the electric lines 12 are formed with pad connecting portions 13 whose widths are wider than those of the other portions.

The size of pad connecting portion 13 will now be described with reference to Fig 3.

P shown in the diagram denotes a pad having a predetermined size to be formed on the substrate provided with electric lines and is schematically illustrated for easily understanding. The dimension in the width direction of the pad connecting portion 13 is the same as width D of the pad D. The dimension in the length direction of the pad connecting portion 13 is set to a value which is obtained by adding an allowance 2ℓ to a length L of the pad P.

The electric line 12 as mentioned above can be formed by a well-known method such that a metal film is formed on the substrate and the metal film is etched by using a mask having a predetermined pattern.

Returning to Fig. 1, an insulating film 14 which covers the electric lines 12 is formed over the substrate 11. A plurality of openings 15 corresponding to the pad connecting portions 13 are formed in the insulating film 14. Each of the opening 15 is formed in a predetermined size so as to expose a part of the pad connecting portion 13.

The size of the opening 15 will now be described with reference to Fig. 4.

The opening 15 has an almost rectangular shape. The size of the opening 15 in the same direction as the width direction of the pad connecting portion 13 is equal to a value which is obtained by adding an allowance 2d to the width D of the pad P. The dimension of the opening 15 in the same direction as the length direction of the pad connecting portion 13 is the same as the length L of the pad P.

The opening 15 as mentioned above can be formed by a well-known method such that the insulating film 14 is formed on the substrate and the insulating film is etched by using a mask having a predetermined pattern.

Fig. 2 shows a state when the substrate formed with the insulating film 14 is seen from the upper position.

As will be understood from the diagram, by superimposing an opening 15 of the insulating film 14 onto the pad connecting portion 13 of the electric line 12, the pad P having predetermine dimensions of length L and width D is formed in the opening 15.

As mentioned above, the pad P having length L and width D is formed by the width dimension D of the pad connecting portion 13 and the length dimension L of the opening 15. As for the pad P, since the pad connecting portion 13 of the length dimension L + 2ℓ is exposed from the opening 15 of the width dimension D + 2d, the positioning of the opening 15 to the pad connecting portion 13 has an allowance of 2ℓ in the length direction and an allowance of 2d in the width direction. Therefore, a positioning deviation of the opening 15 to the pad connecting portion 13 can be absorbed by the above allowances (2ℓ , 2d) in the directions (X, Y directions) which cross perpendicularly. The pad P of a predetermined size (namely, predetermined area) can be obtained.

Fig. 2 shows an example in which another electric line 12' exists between the pads P. The allowance 2d which is added to the size D in the width direction of the opening 15 is set such that the opening 15 does not expose the electric line 12' as well. That is, only the electric line portion which is necessary to form the pad P is exposed from the opening 15 and the other portions of the electric line and the surface of the substrate are covered by the insulating film 14. Thus, even when the allowance dimensions as mentioned above are given to the opening 15, a problem such as a short-circuit between the electric lines or the like does not occur.

In the actual substrate provided with electric lines, in the case where a plurality of pads are arranged along one direction, by giving the dimensional allowances to the electric line side and the opening side of the insulating film as mentioned above, the positioning deviations in all of the directions are permitted and the pad of a predetermined area can be formed. However, in the actual substrate provided with electric lines, in many cases, one train in which the pads are arranged and another train in which the pads are arranged are extended in different directions. Tn such a case, even when the dimensional allowances are merely given to the electric line side and the opening side of the insulating film as mentioned above, a positional deviation between the pads occurs. Thus, there occurs a problem such that when the pads are connected to the semiconductor chip or the like, the connection of each pad is not definitely performed.

Now, as shown in Fig. 5, there is considered as an example the case where one train in which pads P1 are arranged and another train in which pads P2 are arranged are provided in directions which cross each other (in the example, directions cross perpendicularly), and relative offset amounts between the centres of the pads in one train and another train are designated to (x, y) in the X and Y directions, respectively.

in the above design, as shown in Fig. 6, in the case where the position of the opening 15 of the insulating film 14 is deviated to the right in the diagram for the electric line 12, an area of each of the pads P1 and P2 is held to a predetermined size by the allowance dimensions of the pad connecting portion 13 and the opening 15 as described above. However, the offset amounts between the centre of the pad P1 and the centre of the pad P2 fluctuate to (x', y). That is, the amount x increases to x' and differs from the initial design value.

According to the invention, in order to eliminate the relative positional deviations among the pads as mentioned above, the electric lines 12 and the openings 15 are formed under conditions as shown in Fig. 7.

That is, all of the pad connecting portions 13 of the electric lines are formed in parallel with each other. All of the openings 15 which are superpositioned so as to cross the pad connecting portions 13 are also formed in parallel with each other.

In such a design, each of the pads P1 and P2 also has a predetermined area and the relative offset amounts between the train of the pads P1 and the train of the pads P2 are also set to (x, y).

In the design as mentioned above, as shown in Fig. 8, when the position of the opening 15 of the insulating film 14 is deviated to the right in the diagram to the electric line 12, an area of each of the pads P1 and P2 is assured to a predetermined size by the allowance dimensions of the pad constructing portion 13 and the opening 15 as described above.

Further, the offset amounts between the centre of the pad P1 and the centre of the pad P2 are held to (x, y). This is because since the pad connecting portions 13 are in parallel with each other and the openings 15 are in parallel with each other, the centres of the pads P1 and P2 are shifted by only the equal amount in the same direction due to the influence by the positional deviation.

Therefore, all of the pad connecting portions 13 of the electric lines are formed in parallel with each other and all of the openings 15 which are superpositioned to the pad connecting portions so as to cross them are also formed in parallel with each other, so that the above operation and effect are obtained. However, it is considered to be a general way to set the pad connecting portions 13 and the openings 15 so as to be respectively inclined hy 45° for the pad trains.

In the above embodiment, an example in which the pad connecting portions 13 are formed in the front edge portions of the electric lines 12 as regions to form the pads P has been shown. However, it is also possible to construct in a manner such that the openings to expose the front edge portions of the electric lines 12 or the middle portions of the electric lines are formed in the insulating film without forming any special portions and the pads P are formed.

That is, the pad can be also formed from the electric line 12 itself so long as the area which is required to the pad P can be assured. In this case, since the electric line itself is extended like a line, it already has been allowance for the positional deviation of the opening. It is, therefore, sufficient to give the foregoing allowance (2d) to only the opening of the insulating film which is superpositioned to the electric line so as to cross it.

Although the shapes of the pad forming portion (pad connecting portion) of the electric line and the opening of the insulating film are not particularly limited, rectangular shapes are desirable.

According to the invention, by making the direction in which there is an allowance of the pad forming portion (pad connecting portion) of the electric line different from the direction in which there is an allowance of the opening 15, the positional deviation of the opening 15 for the pad forming portion (pad connecting portion) of the electric line can be permitted in all of the directions of the XY plane. Therefore, in a state in which the direction in which there is allowance of the opening 15 certainly perpendicularly crosses the direction in which there is an allowance of the pad forming portion (pad connecting portion) of the electric line, there is need to superposition the opening 15 to the pad forming portion of the electric line. It is sufficient to set a state in which of them cross. Actually, it is preferable to allow the direction in which there is an allowance of the opening 15 to perpendicularly cross the direction in which there is an allowance of the pad forming portion (pad connecting portion) of the electric line in consideration of the easiness of the design.

According to the invention, even if a positional deviation occurs in the opening formed on the substrate provided with electric lines, it is permitted and the substrate provided electric lines which assures the pad having a predetermined area can be obtained. In the case of forming a plurality of pads, the relative positional relation among the pads can be held constant in spite of the positional deviation of the opening.

A substrate provided with electric lines has been described, in which even when a positional deviation between an opening formed in an insulating film and a pad connecting portion occurs, it is permitted and a pad of a predetermined area can be assured. When a plurality of pads are formed a substrate provided with electric lines, even when a positional deviation of the opening as mentioned above occurs, the relative positional relationship is held constant among the pads. Electric lines are extended with allowance dimensions larger than the dimensions of the pads, and openings have allowance dimensions larger than the widths of the electric lines in a region to form the pads and are formed so as to cross the electric lines. A plurality of portions which are exposed as pads of electric lines are provided in parallel with each other and a plurality of corresponding openings are formed in parallel in the portions of the electric lines. In a substrate provided with electric lines on which a first pad train in which a plurality of pads are arranged and a second pad train in which a plurality of pads are arranged are extended and formed in different directions, the portions of the electric lines which are exposed by the openings in the first pad train and those in the second pad train are provided in parallel with allowance dimensions larger than the dimensions of the pads, the openings have allowance dimensions larger than the widths of the electric lines in the regions to form the pads and cross the electric lines, and those openings are formed in parallel with each other.

## Claims

1. An electronic circuit board comprising:
a substrate (11) having electric lines (12) formed thereupon; and
an insulating film (14) covering the electric lines and having an opening;
characterised in that:
the electric lines each have one or more connection pads (13); and
the insulating film has an opening (15) corresponding to each of the connection pads, said opening having a width (D+2d) greater than the width (D) of the corresponding connection pad and a length (L) less than the length (L+2l) of the corresponding connection pad.

2. An electronic circuit board as claimed in claim 1 wherein the connections pads (13) and the openings (15) are of substantially rectangular configuration.

3. An electronic circuit board as claimed in claim 1 or claim 2 wherein the connection pads (13) are substantially parallel to each other and are oriented in a first direction (x).

4. An electronic circuit board as claimed in claim 1 or claim 2 wherein some of the connection pads (13) are substantially parallel to each other and are oriented in a first direction (x) and others of the connection pads are substantially parallel to each other and are oriented in a second direction (y).

5. An electronic circuit board as claimed in claim 4 wherein the first direction (x) is substantially perpendicular to the second direction (y).

6. A method for manufacturing an electronic circuit package comprising the steps of:
forming electric lines (12) upon a substrate (11);
covering the electric lines with an insulating film (14), the insulating film having an opening; and
bonding an electronic component to the exposed connection pad by means of solder;
characterised in that:
said step of forming electric lines further includes forming one or more connection pads (13) for each electric line; and
said step of covering the electric lines with an insulating film further includes the step of providing an opening (15) corresponding to each of the connection pads, said opening having a width (D+2d) greater than the width (D) of the corresponding connection pad and a length (L) less than the length (L+2l) of the corresponding connection pad.

## Patentansprüche

1. Eine elektronische Schaltplatte mit:
einem Substrat (11) mit elektrischen Leitungen (12) darauf, und
einem Isolierfilm (14), der die elektrischen Leitungen bedeckt und eine Öffnung hat,
dadurch gekennzeichnet daß:
die elektrischen Leitungen jeweils über eine oder mehrere Anschlußflächen (13) verfügen, und
der Isolierfilm über eine Öffnung (15) verfügt, die mit den jeweiligen Anschlußflächen übereinstimmt, wobei die Breite (D+2d) der Öffnung größer als die Breite (D) der entsprechenden Anschlußfläche und die Länge (L) kleiner diS die Länge (L+2l) der entsprechenden Anschlußfläche ist.

2. Eine elektronische Schaltplatte nach Anspruch 1, bei der die Anschlußflächen (13) und die Öffnungen (15) im wesentlichen rechteckig sind.

3. Eine elektronische Schaltplatte nach Anspruch 1 oder Anspruch 2, bei der die Anschlußflächen (13) im wesentlichen parallel zueinander liegen und in einer ersten Richtung (x) ausgerichtet sind.

4. Eine elektronische Schaltplatte nach Anspruch 1 oder Anspruch 2, bei der einige der Anschlußflächen (13) im wesentlichen parallel zueinander liegen und in einer ersten Richtung (x) ausgerichtet sind und andere Anschlußflächen im wesentlichen parallel zueinander liegen und in einer zweiten Richtung (y) ausgerichtet sind.

5. Eine elektronische Schaltplatte nach Anspruch 4, bei der die erste Richtung (x) im wesentlichen senkrecht zur zweiten Richtung (y) verläuft.

6. Ein Verfahren zur Herstellung eines elektronischen Schaltgehäuses, das aus folgenden Schritten besteht:
der Herstellung elektrischer Leitungen (12) auf einem Substrat (11),
der Beschichtung der elektrischen Leitungen mit einem Isolierfilm (14), wobei der Isolierfilm über eine Öffnung verfügt, und
dem Bonden einer elektronischen Komponente auf die freiliegende Anschlußfläche mittels Löten,
dadurch gekennzeichnet daß:
der Schritt zur Herstellung der elektrischen Leitungen weiterhin die Herstellung von einer oder mehreren Anschlußflächen (13) für jede elektrische Leitung umfaßt, und
der Schritt zur Beschichtung der elektrischen Leitungen mit einem Isolierfilm weiterhin den Schritt zur Bereitstellung einer Öffnung (15) umfaßt, die mit den jeweiligen Anschlußflächen übereinstimmt, wobei die Breite (D+2d) der Öffnung größer als die Breite (D) der entsprechenden Anschlußfläche und die Länge (L) kleiner als die Länge (L+2l) der entsprechenden Anschlußfläche ist.

## Revendications

1. Une plaquette de circuit électronique comprenant :
un substrat (11) ayant des lignes électriques (12) formées sur lui; et
un film isolant (14) couvrant les lignes électriques et ayant une ouverture;
caractérisé en ce que :
les lignes électriques ont chacune une ou plusieurs zones de connexion (13); et
le film isolant a une ouverture (15) correspondant à chacune des zones de connexion, ladite ouverture ayant une largeur (D+2d) supérieure à la largeur (D) de la zone de connexion correspondante et une longueur (L) inférieure à la longueur (L+2l) de la zone de connexion correspondante.

2. Une plaquette de circuit électronique selon la revendication 1, dans laquelle les zones de connexion (13) et les ouvertures (15) ont une configuration sensiblement rectangulaire.

3. Une plaquette de circuit électronique selon la revendication 1 ou la revendication 2, dans laquelle les zones de connexion (13) sont sensiblement parallèles entre elles et sont orientées dans une première direction (x).

4. Une plaquette de circuit électronique selon la revendication 1 ou la revendication 2, dans laquelle certaines des zones de connexion (13) sont sensiblement parallèles entre elles et sont orientées dans une première direction (x) et d'autres, parmi les zones de connexion, sont sensiblement parallèles entre elles et sont orientées dans une deuxième direction (y).

5. Une plaquette de circuit électronique selon la revendication 4, dans laquelle la première direction (x) est sensiblement perpendiculaire à la deuxième direction (y).

6. Un procédé de fabrication d'un boîtier pour circuit électronique comprenant les étapes consistant à :
former des lignes électriques (12) sur un substrat (11);
couvrir les lignes électriques par un film isolant (14), le film isolant ayant une ouverture; et
lier un composant électronique sur la zone de connexion exposée, au moyen d'une brasure;
caractérisé en ce que :
ladite étape de formation des lignes électriques comprend en outre la formation d'une ou plusieurs zones de connexion (13) pour chaque ligne électrique; et
ladite étape de recouvrement des lignes électriques par un film isolant comprend en outre l'étape consistant à ménager une ouverture (15) correspondant à chacune des zones de connexion, ladite ouverture ayant une largeur (D+2d) supérieure à la largeur (D) de la zone de connexion correspondante et une longueur (L) inférieure à la longueur (L+2l) de la zone de connexion correspondante.
